Europäisches Patentamt

European Patent Office

Office européen des brevets

(19)

(11) Numéro de publication: **0 020 254**
**B1**

(12)

# FASCICULE DE BREVET EUROPEEN

(45) Date de publication du fascicule du brevet: 02.03.83

(51) Int. Cl.³: **H 01 S 3/19**

(21) Numéro de dépôt: **80400725.0**

(22) Date de dépôt: **23.05.80**

(54) **Diòde laser à émission localisée.**

(30) Priorité: 01.06.79 FR 7914177

(43) Date de publication de la demande:
**10.12.80 Bulletin 80/25**

(45) Mention de la délivrance du brevet:
**02.03.83 Bulletin 83/9**

(84) Etats contractants désignés:
**DE GB IT NL**

(56) Documents cités:
**EP - A - 0 014 588**
**DE - A - 2 448 323**
**DE - A - 2 643 503**
**FR - A - 2 297 507**
**FR - A - 2 386 166**
**FR - A - 2 390 829**

Le dossier contient des informations techniques présentées postérieurement au dépôt de la demande et ne figurant pas dans le présent fascicule.

(73) Titulaire: **THOMSON-CSF**
**173, Boulevard Haussmann**
**F-75379 Paris Cedex 08 (FR)**

(72) Inventeur: **Carballes, Jean-Claude**
**"THOMSON-CSF" - SCPI 173, bld Haussmann**
**F-75360 Paris Cedex 08 (FR)**
Inventeur: **Bodere, Alain**
**"Thomson-CSF"-SCPI 173,bld Haussmann**
**F-75360 Paris Cedex 08 (FR)**
Inventeur: **Macaire, Alain**
**"THOMSON-CSF" - SCPI 173, bld Haussmann**
**F-75360 Paris Cedex 08 (FR)**

(74) Mandataire: **Giraud, Pierre et al,**
**THOMSON-CSF SCPI 173, Bld Haussmann**
**F-75379 Paris Cedex 08 (FR)**

Courier Press, Leamington Spa, England.

## Diode laser à émission localisée

L'invention concerne les diodes électroluminescentes de type laser à émission localisée.

On connaît différentes structures de telles diodes dans lesquelles l'émission lumineuse est localisée, notamment la structure dite "en ruban".

En général, dans ces structures, le fonctionnement sur un mode fondamental unique de l'onde lumineuse n'est possible que si l'on ne dépasse pas un certain seuil de puissance lumineuse de l'ordre de 10 milliwatts.

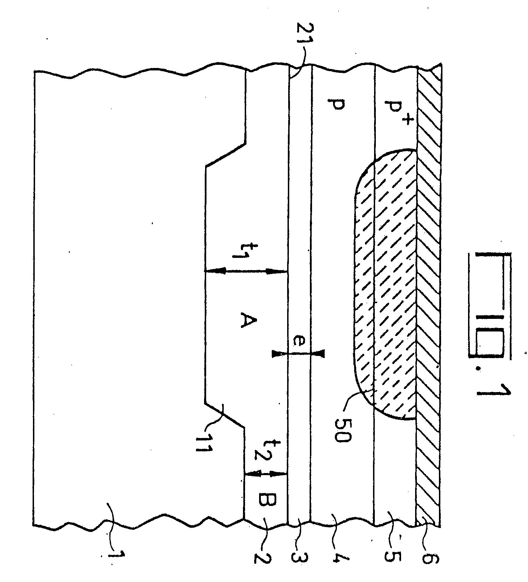

Parmi les structures en ruban, la structure CSP (de l'anglais: channel stripe planar) où le ruban est enterré dans une structure à face supérieure plane, permet d'obtenir une puissance lumineuse supérieure à 10 mW en mode fondamental. Toutefois, cette structure est difficile à réaliser, par suite de particularités qui apparaîtront dans la description sommaire ci-après: sur la face supérieure d'un substrat 1, (figure 1) de GaAs dopé n, a été gravé en canal 11 dans le matériau même de ce substrat. Ensuite, par épitaxie en phase liquide, on a déposé successivement:

—une couche 2 ce $Ga_{0,65}Al_{0,35}As$ dopé n, dont l'épaisseur est telle qu'elle fait disparaître le canal 11 et, en outre, présente une face supérieure 21 pratiquement plane; elle comporte, par conséquent, une zone centrale A d'épaisseur $t_1$ et deux zones latérales B d'épaisseur $t_2$:

—une couche 3 de $Ga_{0,92}Al_{0,08}As$, dont l'épaisseur $e$ est de l'ordre du dixième de micron;

—une couche 4 de $Ga_{0,65}Al_{0,35}As$ dopé p et une couche 5 de GaAs dopé $p^+$ dans lesquelles on a diffusé du zinc renforçant le dopage p dans une zone 50 d'injection localisée du courant de polarisation. Cette zone pénètre dans la couche 4 sans atteindre la couche 3;

—une couche métallique 6 formant contact ohmique.

La localisation de l'émission lumineuse provient de la combinaison de deux effets. D'une part, l'injection de courant est localisée au centre de la structure. D'autre part, la couche 3, source de l'émission, est d'épaisseur suffisamment faible pour que le guidage optique ne soit pas confiné à cette couche. On sait que, dans ce cas, il y a couplage par onde évanescente avec les couches 2 et 4 dites de confinement. Les épaisseurs $t_1$ et $t_2$ ont été choisies pour qu'il en soit ainsi, et dans ces conditions, l'absorption optique induite par le couplage dans le substrat 1 est très importante dans la zone B et négligeable dans la zone A.

La réalisation du canal 11, tout en respectant la planéité de l'interface des couches 3 et 4 est d'une grande difficulté technologique.

L'invention vise à remédier à ces difficultés.

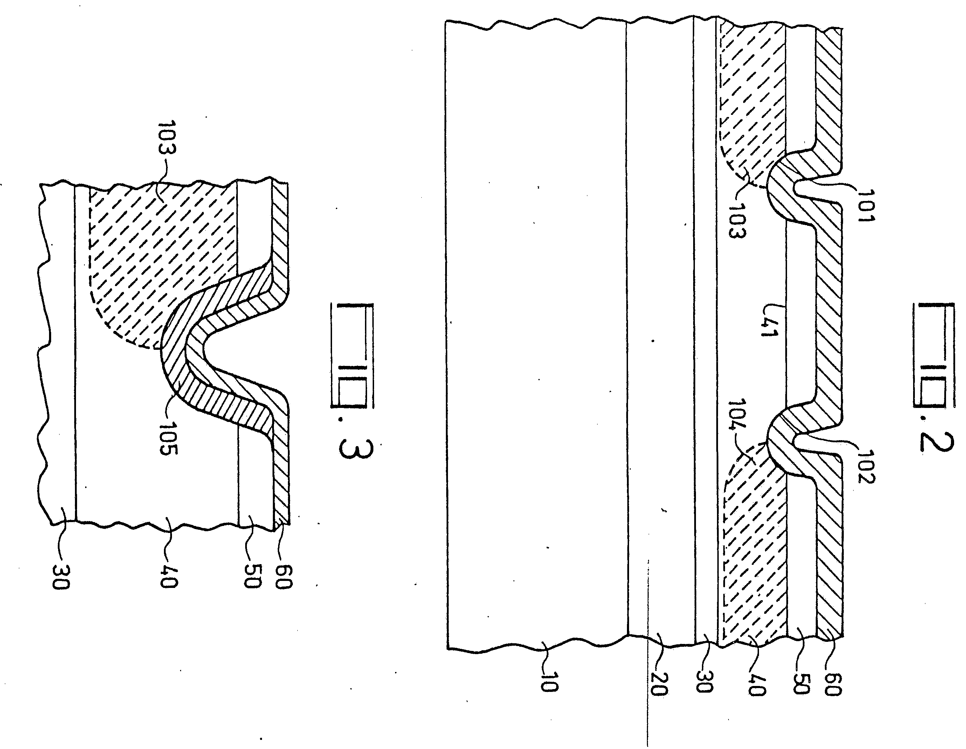

On sait, en outre, par les documents FR—A—2 297 507 (voir fig. 1) et FR—A—2 386 166 (voir fig. 3f à 3j) que l'on peut obtenir la localisation de l'injection de courant au centre de la structure en réalisant un épaulement des couches semiconductrices supérieures de la structure, épaulement revêtu d'un dépôt métallique constituant l'une des électrodes de la diode laser. Cette réalisation présente l'inconvénient de supprimer la planéité de la structure, ce qui rend plus difficile la soudure dite "à l'envers", c'est-à-dire du côté des couches épitaxiales, sources de dégagement calorifique, mode de soudure qui présente l'avantage de diminuer la résistance thermique du dispositif et d'assurer une certaine protection des couches actives de la diode laser contre les dégradations accidentelles survenant après la soudure du boîtier.

On sait enfin, par le document DE—A—2 448 323, qu'il est possible de créer une couche isolante en milieu semiconducteur en effectuant une implantation de protons.

L'invention a pour but de rétablir la planéité de la structure en ayant recours à une implantation de protons limitée aux zones latérales de la structure.

La diode laser selon l'invention, comporte un substrate semiconducteur présentant un premier type de conductivité et une première électrode de fonctionnement, une première couche semiconductrice de confinement électrique en contact avec le substrat présentant le même type de conductivité, une couche semiconductrice photoémissive, une deuxième couche semiconductrice de confinement électrique présentant le type opposé de conductivité, supportant une deuxième électrode. La deuxième couche de confinement comprend une zone centrale dans laquelle le passage du courant électrique est rendu plus facile et des zones latérales dans lesquelles il est rendu moins facile.

En outre, elle comporte deux sillons assurant la séparation entre la zone centrale et les zones latérales, une couche semiconductrice de même type de conductivité que la deuxième couche de confinement, mais plus fortement dopée que celle-ci, recouvrant la deuxième couche de confinement à l'exception des sillons, des régions de la deuxième couche de confinement situées au droit des zones latérales, ayant reçu une implantation de protons telle que le matériau est devenu électriquement isolant.

Elle est caractérisée en ce que l'implantation des protons est effectuée uniquement dans les zones latérales et en ce que la deuxième électrode recouvre l'ensemble de la surface supérieure de la diode.

L'invention sera mieux comprise, et d'autres caractéristiques apparaîtront, au moyen de la description qui suit et des dessins qui l'accompagnent, parmi lesquels:

—la figure 1 représente une structure connue de diode laser;

—les figures 2 et 3 représentent deux modes de réalisation de l'invention.

La structure de la figure 1 a été décrite ci-avant.

La structure de la figure 2, conforme à l'invention, constitue un exemple.

On y trouve un substrat 10 en monocristal d'arseniure de gallium dopé n et une succession de couches obtenues par croissance épitaxiale du substrat, échelonnées comme suit:

a) une couche 20 d'un composé ternaire $Ga_xAl_{1-x}As$ dopé n, où x ne dépasse pas 0,8; sone épaisseur $t_2'$ est de l'ordre de 2 microns;

b) une couche 30 non dopée, d'épaisseur assez faible par exemple 0,1 micron pour que le quidage optique n'y soit pas confiné, d'un composé analogue dans lequel x est compris entre les valeurs 0,8 et 1;

c) une couche 40 d'un composé ternaire $Ga_xAl_{1-x}As$ dopé p, où x ne dépasse pas 0,8; x peut avoir, par exemple la même valeur que dans le composé de la couche 20.

d) une couche 50 de GaAs dopé $p^+$, l'épaisseur de cette couche, de l'ordre de 1 000 angströms, sert à faciliter l'injection de courant dans la diode.

Dans la couche 40, on a creusé deux sillons 101 et 102 par attaque chimique ou par usinage ionique; les sillons entament la couche 50 et également la couche 40 sur une partie de son épaisseur de manière à délimiter la partie 41 de l'interface des couches 40 et 50 à travers laquelle le courant de fonctionnement est injecté. En outre, on a créé, par implantation localisée de protons, deux régions 103 et 104 semi-isolantes en bordure du ruban, sur toute la longueur de celui-ci.

Enfin un dépôt métallique uniforme 60, recouvre à la fois la partie 41 et la portion à nu de la couche 40, est déposé par un moyen classique, tel que l'évaporation de métal sous vide. Elle comporte, par exemple, une succession de couches (non représentées individuellement) de titane, de platine et d'or.

L'invention présente deux avantages:

1. L'injection de courant est plus efficace, par suite des régions isolantes 103 et 104, ce qui permet une diminution du courant de fonctionnement total, donc un meilleur rendement de la diode;

2. Le montage en boîtier est facilité par la planéité de la structure.

Figure 3, on a représenté une partie d'une structure analogue à celle de la figure 2, située à l'endroit du sillon 101. On a déposé dans ce sillon une couche 105 d'un absorbant constitué par exemple par un corps électriquement résistant tel que le carbone; une telle couche limite le courant en dehors de la zone située au droit de l'interface 41, c'est-à-dire qu'elle contribue à délimiter la zone d'injection de courant électrique.

Un tel dépôt absorbant peut être déposé sur les flancs de la structure mésa de la figure 2, c'est-à-dire sur la surface des zones latérales de la couche 40.

Les composés de gallium, d'aluminium et d'arsenic peuvent être remplacés par des composés de gallium, d'arsenic, d'indium, de phosphore et éventuellement d'aluminium.

## Revendications

1. Diode laser à émission localisée, dont la structure comporte un substrat semiconducteur (10) présentant un premier type de conductivité et comportant une première électrode de fonctionnement, une première couche semiconductrice (20) de confinement électrique en contact avec le substrat présentant le même type de conductivité, une couche semiconductrice (30) photoémissive, une deuxième couche semiconductrice (40) de confinement électrique présentant le type opposé de conductivité, supportant une deuxième électrode (60), la deuxième couche (40) de confinement comprenant une zone centrale dans laquelle le passage du courant électrique est rendu plus facile et des zones latérales dans lesquelles il est rendu moins facile, la deuxième couche (40) de confinement électrique comportant deux sillons (101, 102) assurant la séparation entre la zone centrale et les zones latérales, une couche semiconductrice (50) de même type de conductivité que la deuxième couche (40) de confinement, mais plus fortement dopée que celle-ci, recouvrant la deuxième couche (40) de confinement à l'exception des sillons (101, 102), des régions de la deuxième couche (40) de confinement situées au droit des zones latérales, ayant reçu une implantation de protons (103, 104) telle que le matériau est devenu électriquement isolant, caractérisé en ce que l'implantation des protons (103, 104) est effectuée uniquement dans les zones latérales et en ce que la deuxième électrode (60) recouvre l'ensemble de la surface supérieure de la diode.

2. Diode laser suivant la revendication 1 caractérisée en ce que le substrat étant en arséniure de gallium dopé n, les deux couches de confinement électrique sont constituées par des composés de formule $Ga_xAl_{1-x}As$, dans laquelle x ne dépasse pas 0,8, la première couche de confinement étant dopée n et la deuxième dopée p, la couche photoémissive étant constituée par un composé de formule: $Ga_yAl_{1-y}As$ où l'on a: $0,8 \leq y \leq 1$.

3. Diode laser suivant la revendication 2, caractérisée en ce qu'elle comporte une couche de GaAs dopé $p^+$ au contact de la couche de confinement dopée p.

4. Diode laser suivant la revendication 1, caractérisée en ce qu'un dépôt (105) de matériau électriquement résistant est déposé dans les sillons (101, 102).

5. Diode laser suivant l'une quelconque des revendications 1 à 4, caractérisée en ce que les matériaux semiconducteurs constituant la diode comportent, outre le gallium et l'arsenic, de l'indium et du phosphore.

**Patentansprüche**

1. Laserdiode mit lokalisierter Emission, deren Struktur folgende Elemente aufweist: ein Halbleitersubstrat (10) mit einem einen ersten Leichtfähigkeitstyp und einer ersten Betriebselektrode, eine erste elektrische Begrenzungs-Halbleiterschicht (20), die in Berührung mit dem Substrat steht und denselben Leitfähigkeitstyp aufweist, eine Photoemitterende Hableiterschicht (30), eine zweite elektrische Begrenzungshalbleitersschicht (40), mit einem entgegengesetzten Leitfähigkeitstyp, die eine zweite Betriebselektrode (60) trägt, wobei die zweite elektrische Begrenzungschicht (40) einen zentralen Bereich aufweist, in dem der Durchgang des elektrischen Stromes erleichtert ist, sowie seitliche Bereiche in denen der Stromdurchgang erschwert ist, während die zweite elektrische Begrenzungsschicht (40), die zentralen Bereich gegenüber den seitlichen Bereichen abgrenzende zwei Rillen (101, 102) aufweist, eine Halbleiterschicht (50), die denselben Leitfähigkeitstyp wie die zweite Begrenzungsschicht (40) aufweist, aber stärker dotiert ist, also die letztere, und die diese zweite Begrenzungsschicht (40) mit Ausnahme der Rillen (101, 102) bedeckt, und wobei den seitlichen Bereichen der zweiten Begrenzungsschicht (40) gegenüberliegende Bereiche mit einer Protonenimplantation (103, 104) versehen sind, derart, dàss das Material elektrisch isolierend ist, dadurch gekennzeichnet, dass die Protonenimplantation (103, 104) nur in den seitlichen Bereichen erfolgt ist und dass die zweite Betriebselektrode (60) die gesamte obere Fläche der Diode bedeckt.

2. Laserdiode nach Anspruch 1, dadurch gekennzeichnet, dass das Substrat aus $n$-dotierten Galliumarsenid besteht, während die beiden elektrischen Begrenzungsschichten aus Verbindungen der Formel $Ga_xAl_{1-x}As$ bestehen, wobei $x$ nicht grösser ist als 0,8 und die Begrenzungsschicht $n$-dotiert und die zweite Begrenzungsschicht $p$-dotiert ist, wobei die Photoemittierende Schicht aus einer Verbindung der Formel A besteht: $Ga_yAl_{1-y}As$ wo: $0.8 \leq y \leq 1$ ist.

3. Laserdiode nach Anspruch 2, dadurch gekennzeichnet, dass die eine $p^+=$dotierte GaAs-Schicht aufweist, die mit der $p^-$dotierten Begrenzungsschicht in Berührung steht.

4. Laserdiode nach Anspruch 1, dadurch gekennzeichnet, dass in den Rillen (101, 102) eine Schicht (105) aus Material mit hohen elektrischen Widerstand angebracht ist.

5. Laserdiode nach den Ansprüchen 1 bis 4, dadurch gekennzeichnet, dass die Halbleiter die Diode bildenden, ausser Gallium und Arsenik auch, Indium und Phosphor enthalten.

**Claims**

1. Laser diode having a located emission, which structure comprises a semiconductive base (10) showing a conductivity of a first type and having a first operating electrode, a first electric confining semiconductive layer (20) in contact with the base and showing the same type of conductivity, a photoemissive semiconductive layer (30), a second electric confining semiconductive layer (40) showing a conductivity of the opposite type, covered by a second electrode (60), the second electric confining layer (40) comprising a central area in which the flow of electric current is facilitated and side areas in which that flow is hampered, the second electric confining layer (40) comprising two grooves (101, 102) separating the central area from the side areas, a semiconductive layer (50) of the second layer (40) conductivity type, but more highly doped than the latter, covering the secnd confining layer except grooves (101, 102), regions of the second layer (40) positioned upright to the side areas being implanted with protons (103, 104) so that the material has made electrically insulating, characterized in that the protons implantation (103, 104) is carried out in the side areas only and in that the second electrode (60) covers the whole upper surface of the diode.

2. Laser diode according to Claim 1, characterized in that the base is made of n-doped gallium arsenide, in that the two confining layers are made of compounds according to formula: $Gc_xAl_{1-x}As$, in which x is less than 0.8, the first and the second confining layers being n-doped and p-doped, respectively, the photoemissive layer being made of a compound according to formula: $Ga_yAl_{1-y}As$ where $0.8 \leq y \leq 1$.

3. Laser diode according to Claim 2, characterized in that it comprises a layer of $p^+$-doped GaAs into contact with the p-doped confining layer.

4. Laser diode according to Claim 1, characterized in that a coating (105) made of an electrically insulating material is laid down into the grooves (101, 102).

5. Laser diode according to any one of Claims 1 to 4, characterized in that the semiconductive materials of which the diode is made comprises, in addition to gallium and arsenide, indium and phosphorus.

Fig.1

FIG. 2

101    102

60
50
41
103    104
40
30
20
10

FIG. 3

60
50
103    105
40
30